# EUROPEAN PATENT APPLICATION

(11) **EP 3 422 248 A1**
(43) Date of publication of application: **02.01.2019**
(21) Application number: 17892750.5
(22) Date of filing: 22.01.2017
(51) Int. Cl.: G06K 9/00

(54) **FINGERPRINT MODULE**

(71) Applicant: Shenzhen Goodix Technology Co., Ltd., Shenzhen, Guangdong 518045 (CN)
(72) Inventor: XU, Weitian, Shenzhen, Guangdong 518045 (CN); GUO, Yiping, Shenzhen, Guangdong 518045 (CN)
(74) Representative: J A Kemp
(86) International application number: PCT/CN2017/072042
(87) International publication number: WO 2018/133059

(57) **Abstract**

A fingerprint module, which relates to the field of biometric identification. The fingerprint module includes a cover plate (1), a sensor package (2), a circuit board (4), a support frame (3) and an adhesive (5); the cover plate (1) is provided with an ink layer (11) at a lower surface thereof, the sensor package (2) is located below the ink layer (11), a lower surface of the ink layer (11) is covered with the adhesive (5), and the cover plate (1) is fixedly connected with the sensor package (2) via the adhesive (5) below the ink layer (11); the sensor package (2) is fixed over the circuit board (4), and the support frame (3) is arranged on the circuit board (4) at both side; gaps between said constituent parts are filled with the adhesive (5). Compared with the prior art, the fingerprint module has a better structural stability and a thinner overall thickness, which can save more occupied space in application of the whole machine and has a better application effect.

## Description

### TECHNICAL FIELD

The present invention relates to the field of biometric identification and, in particular, to a fingerprint module.

### BACKGROUND

At present, along with the increasing pursuit of product appearance from consumers, internal components and modules of consumer electronics are also in increasing pursuit of perfection in both the performance and technology.

However, existing fingerprint modules cannot meet this requirement.

### SUMMARY

In order to overcome disadvantages of related products in the prior art, the present invention proposes a fingerprint module, which solves shortcomings of occupying space during the whole application process caused by the thicker package and excessive size of the existing fingerprint module.

The present invention solves its technical problems using technical solutions as follow:
The present invention provides a fingerprint module, including: a cover plate, a sensor package, a circuit board, a support frame and adhesive; where the cover plate is provided with an ink layer at its lower surface, the sensor package is located below the ink layer, the ink layer is covered with adhesive underneath, and the cover plate is fixedly connected with the sensor package via the adhesive below the ink layer; the sensor package is fixed over the circuit board; the circuit board is provided with a support frame at both sides, respectively; and the adhesive fills a gap between the components described above.

As a further improvement to the present invention, the sensor package is a wafer level package.

As a further improvement to the present invention, the fingerprint module further includes a reinforcing plate, and the support frame and the circuit board are fixed over the reinforcing plate, respectively.

As a further improvement to the present invention, the cover plate is located inside the support frame.

As a further improvement to the present invention, the support frame has, at a lower end connected with the reinforcing plate, an inward protrusion respectively adjacent to both sides of the circuit board and the sensor package.

As a further improvement to the present invention, the sensor package is fixed over the circuit board by a solder ball and is electrically connected with the circuit board.

As a further improvement to the present invention, the cover plate is a light transmissible material, and is an organic or inorganic material with a thickness ranging from dozens of millimeters to hundreds of millimeters.

As a further improvement to the present invention, the dielectric constant of the cover plate is greater than or equal to 3.

As a further improvement to the present invention, the adhesive is silicone rubber system adhesive or silica-doped adhesive.

The present invention provides a touch terminal, including any one of the fingerprint modules described above.

Compared with the prior art, the present invention has following advantages:
Compared with the prior art, the fingerprint module has a better structural stability and a thinner overall thickness, which can save more occupied space in application of the whole machine and has a better application effect.

### BRIEF DESCRIPTION OF DRAWINGS

In order to more clearly illustrate the technical solutions in the embodiments of the present invention, the drawings used in the embodiments will be briefly described below. Obviously, the drawings in the following description are merely some embodiments of the present invention. For those skilled in the art, other drawings can also be obtained based on these drawings without any creative effort.
FIG. 1 is a schematic structural diagram of an existing fingerprint module;
FIG. 2 is a schematic structural diagram of a biometric identification sensor package sheet of the existing fingerprint module;
FIG. 3 is a schematic structural diagram of an embodiment fingerprint module according to an embodiment of the present invention; and
FIG. 4 is a schematic structural diagram of another embodiment fingerprint module according to an embodiment of the present invention.

### DESCRIPTION OF EMBODIMENTS

In order to make the present invention easier to understand, a more comprehensive description of this invention will be given below with reference to the accompanying drawings. The preferred embodiments of the present invention are given in the accompanying drawings. However, the present invention can be implemented in many different forms and is not limited to the embodiments described herein. Rather, these embodiments are provided so that the disclosure of the present invention will be understood thoroughly and comprehensively.

Unless otherwise defined, all technical and scientific terms used herein have the same meanings as commonly understood by one of ordinary skill in the art to which this invention belongs. The terminology used in the description of this invention is for the purpose of describing particular embodiments only and is not intended to limit the present invention.

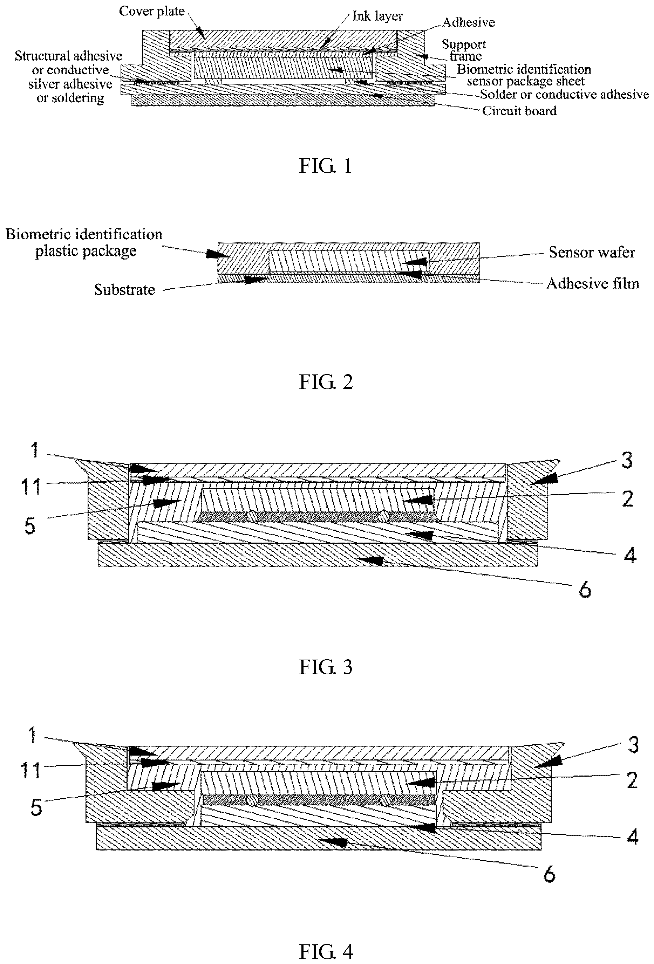

Reference may be made to FIG. 1, the existing fingerprint module is composed of a cover plate, a biometric identification sensor package sheet, a circuit board and a support frame, and the current fingerprint module is assembled with a package sheet; while the biometric identification sensor package sheet, as shown in FIG. 2, is mainly composed of a sensor wafer, a substrate, and a plastic package. Therefore, the thickness is relatively thick as a whole, the entire package is relatively thick due to the thick package body, thereby occupying more space during application of the whole machine.

### Embodiment 1

Reference may be made to FIG. 3 which is a schematic structural diagram of an embodiment fingerprint module according to the present invention, and the fingerprint module includes a cover plate 1, a sensor package 2, a support frame 3, a circuit board 4, adhesive 5 and a reinforcing plate 6.

The sensor package 2 is fixed over the circuit board 4 by a solder ball and is electrically connected with the circuit board 4. The sensor package 2 is a wafer level package, and the wafer level sensor package 2 is a sensor chip directly obtained during the fabrication of the wafer, which is used to collect fingerprint information; compared with the conventional sensor package 2 sheet as shown in FIG. 1, the substrate thickness of the conventional sensor package sheet is generally about 0.2mm (millimeter), and the thickness of the adhesive film is about 0.05mm. Since the sensor package 2 according to the embodiment of the present invention is a wafer level package, which is at least 0.25mm thinner than the conventional sensor package sheet in the overall thickness, thus occupying less space in the fingerprint module mounting process and making the overall thickness of the fingerprint module described in the embodiment of the present invention less than 0.4mm; on the other hand, in the process where the sensor package 2 is fixed to the circuit board 4 by a solder ball, since the solder ball is provided in the wafer level package molding process and due to the conductive property of the solder ball itself, it is unnecessary to achieve soldering by brushing tin on the pad again during SMT (Surface Mount Technology) process, thus the mounting efficiency is improved.

The cover plate 1 is provided with an ink layer 11 for light shielding at its lower surface. In the embodiment of the present invention, the cover plate 1 is a light transmissible material, and is an organic material or inorganic material with a thickness ranging from dozens of millimeters to hundreds of millimeters, such as sapphire, ceramics, glass, etc., the cover plate 1 has a certain light transmittance, which can transmit light of a certain wave length, and the dielectric constant of the cover plate 1 is greater than or equal to 3. In other embodiments of the present invention, the relevant characteristic parameters of the cover plate 1 may be correspondingly adjusted according to actual requirements; the sensor package 2 is located below the ink layer 11, the ink layer 11 is covered with the adhesive 5 underneath, and the cover plate 1 is fixedly connected to the sensor package 2 via the adhesive 5 below the ink layer 11.

The circuit board 4 is provided with a support frame 3 at both sides, respectively, which is retained with a reinforcing plate 6 at its lower surface. The bottom end of the support frame 3 is fixed over the reinforcing plate 6 by structural adhesive, conductive silver adhesive or a soldering manner. The reinforcing plate 6 is used to support the circuit board 4 and the support frame 3 above and to improve the toughness strength of the circuit board 4. The cover plate 1 is located inside the support frame 3.

A gap will be generated between mutual positions of the internal components of the fingerprint module during the mounting process; for example, between the support frame 3 and the sensor package 2, between the support frame 3 and the circuit board 4, etc. In the embodiment of the present invention, the gap between the internal components of the fingerprint module is filled with the adhesive 5. The adhesive 5 is silicone rubber system adhesive or silica-doped adhesive, having characteristics such as low thermal expansion coefficient and high impact strength, which is used to support spatial structure of the internal components of the fingerprint module; at the same time, since its characteristics can effectively protect stability of the sensor package 2 in terms of structure and property, offset or damage to the internal components of the fingerprint module caused by external reasons such as collisions are also avoided.

In the embodiment of the present invention, compared with the prior art, the fingerprint module has a better structural stability and a thinner overall thickness, which can save more occupied space in application of the whole machine and has a better application effect.

### Embodiment 2

Based on the foregoing embodiment, reference may be made to FIG. 4 which is a schematic structural diagram of another embodiment fingerprint module according to an embodiment of the present invention.

The support frame 3 has, at its lower end connected with the reinforcing plate 6, an inward protrusion respectively adjacent to both sides of the circuit board 4 and the sensor package 2. Since the protrusion fills part of the gaps inside the fingerprint module, the adhesive 5 used to fill the gap between the internal components of the fingerprint module is reduced.

When the thermal expansion coefficient of the adhesive 5 selected for the fingerprint module is relatively high, since the volume of the adhesive 5 will expand due to the increase of the external temperature, the more the adhesives 5 is used, the greater the whole volume of the adhesive 5 changes. In order to reduce the influence of volume change of the adhesive 5, use amount of the adhesive 5 is reduced by the structure described in the embodiment of the invention, which can effectively improve the structure stability of the fingerprint module; on the other hand, when the thermal expansion coefficient of the adhesive 5 is relatively low, the structure of the fingerprint module described in the above embodiment can also be selected according to actual requirements.

### Embodiment 3

Based on the foregoing embodiment, an embodiment of the present invention further provides a touch terminal, which includes the fingerprint module described in the above embodiments and has corresponding function modules and beneficial effects of the fingerprint module. For details, reference may be made to the embodiments of the fingerprint module described above, and details will be omitted in the embodiments of the present invention.

Above embodiments are preferred embodiments of the present invention, but the implementations of the present invention are not limited thereto. Any change, modification, substitution, combination, and simplification made without departing from the spirit and principles of the present invention should be equivalent replacements, all of which are included in the protection scope of the present invention.

## Claims

1. A fingerprint module, comprising:
a cover plate, a sensor package, a circuit board, a support frame and an adhesive; wherein
the cover plate is provided with an ink layer at a lower surface thereof, the sensor package is located below the ink layer, a lower surface of the ink layer is covered with the adhesive, and the cover plate is fixedly connected with the sensor package via the adhesive below the ink layer;
the sensor package is fixed over the circuit board, and the support frame is arranged on the circuit board at both side of the sensor package;
the adhesive fills gaps between the cover plate, the sensor package, the circuit board and the support frame.

2. The fingerprint module according to claim 1, wherein the sensor package is a wafer level package.

3. The fingerprint module according to claim 1, wherein the fingerprint module further comprises a reinforcing plate, and the support frame and the circuit board are fixed over the reinforcing plate, respectively.

4. The fingerprint module according to claim 3, wherein the cover plate is located inside the support frame.

5. The fingerprint module according to claim 4, wherein the support frame has, at a lower end connected with the reinforcing plate, an inward protrusion respectively adjacent to both sides of the circuit board and the sensor package.

6. The fingerprint module according to claim 1, wherein the sensor package is fixed over the circuit board by a solder ball and is electrically connected with the circuit board.

7. The fingerprint module according to claim 1, wherein the cover plate is a light transmissible material, and is an organic or inorganic material with a thickness ranging from dozens of millimeters to hundreds of millimeters.

8. The fingerprint module according to claim 7, wherein the dielectric constant of the cover plate is greater than or equal to 3.

9. The fingerprint module according to claim 1, wherein the adhesive is silicone rubber system adhesive or silica-doped adhesive.

10. A touch terminal, comprising a fingerprint module according to any one of claims 1-9.
